# EUROPÄISCHE PATENTSCHRIFT

(11) **EP 1 877 268 B1**
(45) Veröffentlichungstag und Bekanntmachung des Hinweises auf die Patenterteilung: **15.09.2010**
(21) Anmeldenummer: 06754870.1
(22) Anmeldetag: 26.04.2006
(51) Int. Cl.: B60D 1/62

(54) **ELEKTRISCHE SCHNITTSTELLENVORRICHTUNG ZUM ÜBERTRAGEN ELEKTRISCHER ENERGIE ZWISCHEN EINEM FAHRZEUG UND EINEM AN DAS FAHRZEUG ANKOPPELBAREN ARBEITSGERÄT**
ELECTRIC INTERFACE DEVICE FOR THE TRANSMISSION OF ELECTRIC POWER BETWEEN A VEHICLE AND AN IMPLEMENT COUPLED TO THE VEHICLE
ENSEMBLE INTERFACES ELECTRIQUES POUR LA TRANSMISSION D'ENERGIE ELECTRIQUE ENTRE UN VEHICULE A MOTEUR ET UNE MACHINE DE TRAVAIL POUVANT ETRE COUPLEE AU VEHICULE A MOTEUR

(30) Priorität: 26.04.2005 DE 102005019362
(43) Veröffentlichungstag der Anmeldung: 16.01.2008
(73) Patentinhaber: Deere & Company, Moline, IL 61265-8098 (US)
(72) Erfinder: TARASINSKI, Nicolai, 67227 Frankenthal (DE)
(74) Vertreter: Magin, Ludwig Bernhard
(86) Internationale Anmeldenummer: PCT/EP2006/061859
(87) Internationale Veröffentlichungsnummer: WO 2006/114437

(56) Entgegenhaltungen:
- EP-A- 1 029 745
- US-A1- 2002 125 771
- US-A1- 2004 160 123

## Beschreibung

Die Erfindung betrifft eine elektrische Schnittstellenvorrichtung zum Übertragen elektrischer Energie zwischen einem Fahrzeug und einem an das Fahrzeug ankoppelbaren Arbeitsgerät. Das Fahrzeug ist insbesondere ein landwirtschaftliches oder industrielles Nutzfahrzeug. Die elektrische Schnittstellenvorrichtung umfasst eine Fahrzeugschnittstelle, eine Arbeitsgeräteschnittstelle und elektrische Leitungen. Mit den elektrischen Leitungen sind einerseits die Fahrzeugschnittstelle mit einer elektrischen Energiequelle des Fahrzeugs und andererseits die Arbeitsgeräteschnittstelle mit einem elektrischen Verbraucher verbindbar. Die Fahrzeugschnittstelle ist komplementär zu der Arbeitsgeräteschnittstelle ausgebildet und mit der Arbeitsgeräteschnittstelle reversibel verbindbar. Des Weiteren betrifft die vorliegende Erfindung ein Fahrzeug und ein Arbeitsgerät mit einer elektrischen Schnittstellenvorrichtung. Des Weiteren betrifft die vorliegende Erfindung ein Fahrzeug und ein Arbeitsgerät.

Schnittstellenvorrichtungen der eingangs genannten Art sind seit Langem aus dem Stand der Technik bekannt. EP 1029745 beschreibt eine gattungsgemäße Vorrichtung nach dem Oberbegriff des Anspruchs 1. Insbesondere an in Form von Traktoren ausgebildete Fahrzeuge werden Arbeitsgeräte oder Anhänger angekoppelt, welche elektrische Verbraucher aufweisen. Als solche elektrischen Verbraucher kommen beispielsweise Elektromotoren, Pumpen, Lüfter, Beleuchtungseinrichtungen, Heiz- oder Kühleinrichtungen, Ventile, Elektromagnete oder Stellantriebe in Frage. Die elektrischen Verbraucher der Arbeitsgeräte oder Anhänger werden über das elektrische Leitungsnetz des Fahrzeugs versorgt, wobei das elektrische Leitungsnetz einen elektrischen Energieerzeuger und/oder Speicher aufweist, welcher beispielsweise in Form einer Lichtmaschine, einer Brennstoffzelle oder eines Generators, im Fall eines Energieerzeugers, oder in Form eines Kondensators oder einer Batterie beziehungsweise eines Akkumulators, im Fall eines Speichers, ausgebildet sein kann.

Zur Versorgung von landwirtschaftlichen Arbeits- beziehungsweise Anbaugeräten mit elektrischer Energie ist unter anderem eine ISO Norm 11783-2 vorgesehen, welche einen Standard für die konstruktive Ausgestaltung der elektrischen Schnittstelle zwischen Fahrzeug und Arbeitsgerät festlegt. Der eigentliche elektrische Energiefluss über eine solche Schnittstelle wird jedoch von dieser Norm nicht erfasst. Insbesondere bei Verbrauchern eines Arbeitsgeräts mit großem elektrischen Leistungsbedarf können bei einem aus Fahrzeug und Arbeitsgerät bestehenden Gespann Situationen der Überlastung entstehen, welche unter Umständen die Betriebssicherheit gefährden können.

Der vorliegenden Erfindung liegt daher die Aufgabe zugrunde, eine elektrische Schnittstellenvorrichtung der eingangs genannten Art anzugeben und weiterzubilden, durch welche die vorgenannten Probleme überwunden werden. Insbesondere soll eine elektrische Schnittstellenvorrichtung angegeben und weitergebildet werden, mit welcher die Betriebssicherheit gefährdenden Situationen zumindest weitgehend vermieden werden können.

Die Aufgabe wird erfindungsgemäß durch die Lehre des Patentanspruchs 1 gelöst. Weitere vorteilhafte Ausgestaltungen und Weiterbildungen der Erfindung gehen aus den Unteransprüchen hervor.

Erfindungsgemäß ist eine elektrische Schnittstellenvorrichtung der eingangs genannten Art gekennzeichnet durch eine der Fahrzeugschnittstelle zugeordnete Messeinrichtung und/oder eine der Fahrzeugschnittstelle zugeordnete Stelleinrichtung. Mit der Messeinrichtung ist mindestens eine elektrische Zustandsgröße der zwischen dem Fahrzeug und dem Arbeitsgerät übertragenen elektrischen Energie quantifizierbar. Mit der Stelleinrichtung ist mindestens eine elektrische Zustandsgröße der zwischen dem Fahrzeug und dem Arbeitsgerät übertragenen elektrischen Energie veränderbar.

Erfindungsgemäß ist zunächst erkannt worden, dass bei einer herkömmlichen Anordnung zwischen Fahrzeug und Arbeitsgerät in gewissen Grenzen die Betriebssicherheit sichergestellt ist, beispielsweise durch das Vorsehen von elektrischen Sicherungen zum Schutz vor Überlastung der vorgesehenen elektrischen Leitungen. Solche Sicherungen bewirken jedoch lediglich, dass der in einzelnen Leitungsabschnitten fließende elektrische Strom einen vorgegebenen Grenzwert, beispielsweise 16 A, nicht überschreitet, da ansonsten die Sicherung anspricht. Eine fahrzeugseitige Reaktion auf eine hohe Belastung der am Fahrzeug selbst vorgesehenen elektrischen Verbraucher, beispielsweise in Form eines Anhebens der Drehzahl des Verbrennungsmotors des Fahrzeugs, mag unter Umständen vorgesehen sein. Eine Berücksichtigung einer hohen Belastung eines elektrischen Verbrauchers eines an das Fahrzeug ankoppelbaren Arbeitsgeräts ist jedoch nicht vorgesehen. Gerade in diesem Zusammenhang kann es jedoch sehr leicht zu Überlastungen für die fahrzeugseitige elektrische Energieversorgung kommen, wenn nämlich beispielsweise ein Elektromotor des Arbeitsgeräts blockiert und es hierdurch zu einer einem Kurzschluss vergleichbaren Situation kommt.

Die erfindungsgemäße elektrische Schnittstellenvorrichtung ist insbesondere auch unabhängig von der Anzahl der dem Arbeitsgerät zugeordneten elektrischen Verbraucher, die über die elektrische Schnittstellenvorrichtung mit dem Fahrzeug verbindbar sind. Mit anderen Worten ist lediglich eine Schnittstellenvorrichtung auch für mehrere elektrische Verbraucher vorgesehen. Hierbei können die elektrischen Verbraucher räumlich unabhängig von der erfindungsgemäßen elektrischen Schnittstelleneinrichtung angeordnet bzw. vorgesehen sein.

Daher ist in erfindungsgemäßer Weise vorgesehen, beispielsweise den Strom zu messen, der zwischen dem Fahrzeug und dem Arbeitsgerät übertragen wird, und zwar mit der der Fahrzeugschnittstelle zugeordneten Messeinrichtung. Damit die Messung der elektrischen Zustandsgröße der zwischen dem Fahrzeug und dem Arbeitsgerät übertragenen elektrischen Energie ein möglichst genaues Ergebnis liefert, ist die Messeinrichtung der Fahrzeugschnittstelle zugeordnet und ist somit in der Lage, die tatsächlich über die Fahrzeugschnittstelle übertragene elektrische Energie zu messen bzw. zu qualifizieren. In ähnlicher Weise verhält es sich mit der Stelleinrichtung, die ebenfalls der Fahrzeugschnittstelle zugeordnet ist und mit der zumindest eine elektrische Zustandsgröße der elektrischen Energie veränderbar ist, welche zwischen dem Fahrzeug und Arbeitsgerät übertragen wird.

Als zwischen dem Fahrzeug und dem Arbeitsgerät übertragene elektrische Energie könnte nun ein- oder mehrphasiger Wechselstrom, Drehstrom und/oder Gleichstrom vorgesehen sein. Idealerweise stellt die erfindungsgemäße Schnittstellenvorrichtung fahrzeugseitig Anschlüsse für sämtliche Stromarten zur Verfügung, wobei arbeitsgeräteseitig eine Arbeitsgeräteschnittstelle beispielsweise lediglich die Verbindungen zum Übertragen von elektrischem Strom aufweist, die das entsprechende Arbeitsgerät tatsächlich verwendet. Hierdurch kann in vorteilhafter Weise eine vielseitig verwendbare Fahrzeugschnittstelle realisiert werden, an welche auf den Einzelfall abgestimmte Arbeitsgeräteschnittstellen anschließbar sind.

Eine elektrische Zustandsgröße könnte die elektrische Spannung, der elektrische Strom, der elektrische Widerstand, die Frequenz eines Wechsel- oder Drehstroms, die Phasenlage eines Wechsel- oder Drehstroms und/oder die Kapazität eines elektrischen Energiespeichers sein. Auch hierbei ist idealerweise vorgesehen, die Fahrzeugschnittstelle mit entsprechenden Messeinrichtungen auszustatten, die eine Bestimmung sämtlicher relevanter elektrische Zustandsgrößen ermöglicht.

Ganz besonders bevorzugt ist vorgesehen, mit der Messeinrichtung den elektrischen Strom zu messen, welcher zwischen dem Fahrzeug und dem Arbeitsgerät fließt. Anhand dieser elektrischen Zustandsgröße kann fahrzeugseitig ein vielseitiges Energiemanagementsystem realisiert werden, welches beispielsweise eine fahrzeugseitige Erzeugung bzw. zur Verfügung Stellung elektrischer Energie für das Arbeitsgerät sicherstellt. Hierzu ist unter Umständen die Drehzahl eines Verbrennungsmotors des Fahrzeugs zu erhöhen, wodurch ein von dem Verbrennungsmotor angetriebener Generator mit erhöhter mechanischer Leistung angetrieben wird, wenn aufgrund der arbeitsgeräteseitigen Auslastung der zu übertragende elektrische Strom sich kurzzeitig erhöht.

Nun gibt es ganz allgemein viele Möglichkeiten, die elektrische Spannung eines elektrischen Schaltkreises zu messen. Im Folgenden werden bevorzugte Ausführungsformen der Spannungsmessung im Zusammenhang mit der erfindungsgemäßen elektrischen Schnittstellenvorrichtung erläutert.

So könnte an mindestens einer Leitung ein Messwiderstand vorgesehen sein, an welchem mit einer Spannungsmesseinheit ein Spannungsabfall messbar ist. Der zwischen dem Fahrzeug und dem Arbeitsgerät fließende Strom kann dann nach dem Ohm'schen Gesetz berechnet werden.

Es könnte auch an mindestens einer Leitung ein Messwiderstand vorgesehen sein, an welchem ein Temperatursensor vorgesehen ist. Der Temperatursensor detektiert die Temperatur, den Temperaturverlauf oder die Erwärmung des Messwiderstands und erzeugt hiervon abhängige Messsignale. Eine Kalibrierung und/oder einen Abgleich mit der Umgebungstemperatur des Fahrzeugs könnte hierzu erforderlich sein. Vorzugsweise wird anhand der Erwärmung des Messwiderstands eine Belastungskennzahl errechnet, welche beispielsweise einem Fahrzeugbediener auf einer Skala zwischen einer minimalen und einer maximalen Auslastung des Arbeitsgeräts angezeigt werden könnte.

In mindestens einer Leitung könnte eine elektrische Sicherung vorgesehen sein, an welcher mit einer Spannungsmesseinheit ein Spannungsabfall messbar ist. Alternativ oder zusätzlich könnte mit einer Spannungsmesseinheit der Spannungsabfall an einem vorgesehenen Leitungsabschnitt messbar sein. Weiterhin könnte mit einer Spannungsmesseinheit der Spannungsabfall an einem Schaltelement gemessen werden, beispielsweise an den Kontakten eines Schaltelements. Auch in diesen Fällen kann der zwischen dem Fahrzeug und dem Arbeitsgerät beziehungsweise durch die entsprechende Leitung fließende Strom nach dem Ohm'schen Gesetz berechnet werden.

Besonders bevorzugt ist ein Magnetfeldsensor vorgesehen, welcher in unmittelbarer Nähe einer elektrischen Leitung angeordnet ist. Mit dem Magnetfeldsensor ist das Magnetfeld detektierbar bzw. quantifizierbar, welches durch den elektrischen Stromfluss durch diese elektrische Leitung zwischen dem Fahrzeug und dem Arbeitsgerät verursacht wird. Der Magnetfeldsensor könnte einen Hall-Sensor aufweisen oder nach dem magnetoresistiven Prinzip arbeiten. Der Magnetfeldsensor erzeugt ein vom Magnetfeld abhängiges Signal, was einer Steuereinrichtung beziehungsweise der Messeinrichtung zugeleitet wird.

Ganz besonders bevorzugt ist mindestens ein Messmittel vorgesehen, mit welchem die elektrische Spannung in räumlicher Nähe der Arbeitsgeräteschnittstelle, der Fahrzeugschnittstelle, der elektrischen Energiequelle und/oder eines elektrischen Speichers messbar ist. Demgemäß ist nicht nur an der Fahrzeugschnittstelle oder Arbeitsgeräteschnittstelle jeweils ein Messmittel vorgesehen, sondern auch an einer elektrischen Energiequelle des Fahrzeugs, beispielsweise an einem Generator oder an einer Lichtmaschine, und/oder an einem elektrischen Speicher, beispielsweise an der Fahrzeugbatterie. Hierdurch können die aktuell vorliegenden Spannungszustände an den einzelnen Stellen des elektrischen Schaltkreises gemessen und einer entsprechenden Steuereinrichtung zugeführt werden, so dass in besonders vorteilhafter Weise ein Energiemanagementsystem für das Gespann bestehend aus Fahrzeug und Arbeitsgerät erzielt werden kann, welches umfassende Steuer- und Regelfunktionen aufweist. Weiterhin können hierdurch umfassende Überwachungs- und Diagnosefunktionen bereitgestellt werden mit welchen beispielsweise eine Überlastung der elektrischen Anlage vermieden werden kann.

Die Stelleinrichtung ist bevorzugt derart ausgebildet, dass die Fahrzeugschnittstelle spannungsfrei schaltbar ist. Dies ist insbesondere für den Fall einer manuellen Kopplung des Arbeitsgeräts an das Fahrzeug hilfreich und/oder aus Sicherheitsgründen erforderlich.

Ganz besonders bevorzugt ist mit der Stelleinrichtung mindestens eine elektrische Zustandsgröße an der Fahrzeugschnittstelle veränderbar. Demgemäß umfasst die Fahrzeugschnittstelle entsprechende Mittel, mit welchen dies möglich ist. Hierzu können beispielsweise Umrichter, Spannungswandler und/oder Transformatoren zählen.

Gemäß einer bevorzugten Ausführungsform umfasst die erfindungsgemäße Schnittstellenvorrichtung mindestens eine Regeleinrichtung zur Regelung mindestens einer elektrischen Zustandsgröße. Mit der Regeleinrichtung sind die Istwerte einer elektrischen Zustandsgröße mit vorgebbaren Sollwerten einer elektrischen Zustandsgröße vergleichbar. Die Istwerte könnten beispielsweise von der Messeinrichtung ermittelt werden. Bei einer Abweichung eines Istwerts von einem Sollwert könnte bei einer bevorzugten Regelstrategie mittels eines Stellglieds die Drehzahl eines Verbrennungsmotors des Fahrzeugs variiert werden, und zwar vorzugsweise derart, dass einerseits die elektrische Energieversorgung des Fahrzeugs und des Arbeitsgeräts sichergestellt und andererseits dass hierbei die eine Minimierung des Kraftstoffverbrauchs des Fahrzeugs erzielbar ist. Das Stellglied bzw. die Stellvorrichtung wäre in diesem Fall eine Verbrennungsmotoransteuerung.

Alternativ hierzu wäre auch eine Regelstrategie denkbar, mit welcher die Fahrgeschwindigkeit des Fahrzeugs derart variiert wird, dass hierbei eine Minimierung der Abweichung erzielt wird. Das Stellglied bzw. die Stellvorrichtung wäre in diesem Fall eine Getriebeansteuerung für ein stufenlos variables Getriebe eines Traktors. Eine weitere Regelstrategie bei einer Abweichung eines Istwerts von einem Sollwert könnte sein, dass die entsprechend abweichende(n) elektrische Zustandsgröße(n) mittels mindestens eines Stellglieds derart variierbar ist (sind), dass die Abweichung minimierbar ist (sind), wobei hier die Fahrgeschwindigkeit oder die Drehzahl des Verbrennungsmotors beibehalten werden könnte. Gegebenenfalls überschüssige elektrische Energie könnte einem elektrischen Speicher zugeführt werden. Das Stellglied der Regeleinrichtung könnte beispielsweise einzelne oder alle Komponenten der Stelleinrichtung umfassen.

Ganz besonders bevorzugt könnte als Regelstrategie vorgesehen sein, dass die Drehzahl einer Zapfwelle des Fahrzeugs derart variierbar ist, dass hierbei die Minimierung der Abweichung erzielbar ist. Das Stellglied bzw. die Stellvorrichtung wäre in diesem Fall eine Zapfwellengetriebeansteuerung. Mit einer Zapfwelle des Fahrzeugs ist mechanische Energie auf ein an das Fahrzeug angekoppeltes Arbeitsgerät übertragbar, so dass das Arbeitsgerät über die Zapfwelle vom Fahrzeug - neben der elektrischen Versorgung eines elektrischen Antriebs des Arbeitsgeräts - auch mechanisch antreibbar ist. Diese Regelstrategie könnte sich auch auf das Drehmoment beziehen, welches mit der Zapfwelle auf das Arbeitsgerät übertragen wird. Es ist auch denkbar, dass eine Kombination der oben genannten Regelstrategien zur Anwendung kommt, nämlich eine Variation der Fahrgeschwindigkeit des Fahrzeugs in Verbindung mit einer Variation der Drehzahl der mechanischen Zapfwelle, so dass die Abweichung minimierbar ist. Eine solche Regelstrategie könnte zum Vermeiden einer hohen Belastung eines elektrischen Verbrauchers eines an das Fahrzeug ankoppelbaren Arbeitsgeräts dienen, falls dies mit der Messeinrichtung detektiert wird. Als elektrischer Verbraucher für ein solches Beispiel wäre ein Elektromotor des als Rundballenpresse ausgestalteten Arbeitsgeräts denkbar, welcher den Erntegutaufnehmer (Pickup) der Rundballenpresse antreibt. Falls das Gespann bestehend aus Fahrzeug und Rundballenpresse zu schnell fährt und mit dem Erntegutaufnehmer zu viel Stroh aufzunehmen ist, könnte der Erntegutaufnehmer und somit der den Erntegutaufnehmer antreibende Elektromotor der Rundballenpresse blockieren und somit eine hierzu vergleichbare Kurzschlusssituation herbeiführen. Damit dies verhindert wird, könnte mit der Regelstrategie die Fahrgeschwindigkeit des Fahrzeugs und die Drehzahl der Zapfwelle vorzeitig reduziert werden. Mit der Zapfwelle könnte in diesem Beispiel die zur Ballenbildung erforderlichen Komponenten der Pressekammer angetrieben werden. Hierdurch kann letztendlich eine Überlastung des elektrischen Netzes des Fahrzeugs und/oder einzelner elektrischer Verbraucher des Fahrzeugs vermieden werden.

In einer ganz besonders bevorzugten Ausführungsform wirkt eine Fahrzeugsteuereinrichtung mit der Regeleinrichtung derart zusammen, dass die Gesamtleistung des Fahrzeugs optimierbar und/oder dass der Kraftstoffverbrauch des Fahrzeugs minimierbar ist. Mit der Fahrzeugsteuereinrichtung könnten der Verbrennungsmotor, das Getriebe, die Zapfwelle bzw. das Zapfwellengetriebe sowie weitere Verbraucher (beispielsweise eine Hydraulikpumpe) des Fahrzeugs angesteuert werden. Dementsprechend ist die Regelstrategie bei dieser Ausführungsform dahingehend, die Gesamtleistung des Fahrzeugs zu optimieren, wobei diese auf den jeweiligen aktuellen Betriebsmodus bezogen sein kann (z.B. das Pflügen mit einem Traktor). Alternativ oder zusätzlich könnte eine Regelstrategie auch einen möglichst geringen Kraftstoffverbrauch des Fahrzeugs bei dem jeweils aktuellen Betriebsmodus zum Ziel haben.

Ganz besonders bevorzugt ist bei einer ein- oder mehrphasigen Wechselstromübertragung über die Schnittstelle die Spannung und/oder die Frequenz und/oder die Phasenlage der Wechselspannung veränderbar. Dies könnte beispielsweise vom Fahrzeugbediener initiiert werden.

Bevorzugt ist mindestens ein Priorisierungsmittel vorgesehen, mit welchem die Priorisierung der elektrischen Energieversorgung der am Fahrzeug vorgesehenen elektrischen Verbraucher und der elektrischen Verbraucher des Arbeitsgeräts priorisierbar sind. Dies könnte beispielsweise mit einer Steuereinrichtung realisiert werden, welche die elektrische Energieversorgung sämtlicher relevanter elektrischer Verbraucher steuert bzw. regelt. Unter relevanten elektrischen Verbrauchern sind insbesondere elektrische Verbraucher mit einem hohen elektrischen Energieverbrauch gemeint.

Insbesondere beim Vorliegen von Extremsituationen und nicht zuletzt aus Sicherheitsgründen könnte vorgesehen sein, dass beim Überschreiten eines vorgebbaren Grenzwerts einer elektrischen Zustandsgröße die Leistung eines Verbrennungsmotors des Fahrzeugs variierbar - insbesondere anhebbar - ist. Auch könnten selbsttätige Sicherungsmaßnahmen vorgenommen werden, welche beispielsweise von einer Steuereinrichtung initiiert werden, welche die elektrische Energieversorgung sämtlicher elektrischen Verbraucher steuert bzw. regelt. Hierzu könnte beispielsweise eine Reduzierung der elektrischen Spannung, des elektrischen Stroms, der Fahrzeuggeschwindigkeit und/oder das Abschalten des elektrischen Energieflusses über die Schnittstelle zählen.

Im Rahmen einer konkreten Ausführungsform könnte die Fahrzeugschnittstelle eine Steckdose oder einen Stecker aufweisen. Die Arbeitsgeräteschnittstelle könnte dann einen zur Steckdose der Fahrzeugschnittstelle komplementär ausgebildeten Stecker oder eine zum Stecker der Fahrzeugschnittstelle komplementär ausgebildete Steckdose aufweisen. Eine auf Stecker und Steckdose basierende Ausgestaltung der Fahrzeugschnittstelle bzw. Arbeitsgeräteschnittstelle ist für Arbeitsgeräte zweckmäßig, welche schnell und des öfteren an das Fahrzeug zu koppeln sind. Gegebenenfalls könnte die Steckdose bzw. der Stecker an einer entsprechenden mechanischen Schnittstelle zwischen Arbeitsgerät und Fahrzeug vorgesehen sein, beispielsweise bei einer Pickup-Hitch in Sinn der DE 100 65 161 A1, so dass unter Umständen eine automatische mechanische und elektrische Kopplung zwischen Arbeitsgerät und Fahrzeug möglich ist.

Die reversible Verbindung zwischen der Fahrzeugschnittstelle und der Arbeitsgeräteschnittstelle könnte allerdings auch mit einer Klemmverbindung oder einer Schraubverbindung herstellbar sein, welche vorzugsweise von einem Gehäuse oder Kasten gegen Witterungseinflüsse bzw. Wasser geschützt ist.

In einer ganz besonders bevorzugten Ausführungsform ist ein Auswertemittel vorgesehen, mit welchem die elektrische Leistung, die elektrische Energie und/oder der elektrische Widerstand eines elektrischen Verbrauchers ermittelbar ist. Hierbei kann mit dem Auswertemittel einerseits die einzelnen elektrischen Zustandsgrößen in ihrem Betrag nach anhand der Signale von Sensoren und/oder Detektoren beziehungsweise anhand der Messwiderstandswerte ermittelt werden. Weiterhin könnte auch vorgesehen sein, dass das Auswertemittel die Messwerte zu mehreren elektrischen Zustandsgrößen hinsichtlich einer Gesamtsituation der elektrischen Versorgung der Verbraucher des Fahrzeugs und des Arbeitsgeräts analysiert und an eine Steuereinrichtung weiterleitet, so dass der jeweiligen Situation des Gespanns entsprechend optimierte Regelstrategien umgesetzt werden können.

Besonders bevorzugt ist eine Warneinrichtung vorgesehen, mit welcher ein Fahrzeugbediener beim Überschreiten vorgebbarer Grenzwerte für elektrische Zustandsgrößen gewarnt wird. Eine solche Warnung könnte beispielsweise mittels akustischer und/oder optischer Signale erfolgen.

Damit ein Fahrzeugbediener stets über den Zustand - insbesondere der relevanten elektrischen Komponenten - des Fahrzeugs und des daran angekoppelten Arbeitsgeräts informiert ist, könnte eine Anzeigeeinheit vorgesehen sein, mit welcher der elektrische Strom, die elektrische Spannung, die elektrische Leistung, die Belastungskennzahl, der Verbraucherwiderstand und/oder die elektrische Energie angezeigt wird. Letztendlich könnte eine solche Anzeigeeinheit die relevanten elektrischen Zustandsgrößen anzeigen, die mit der Messeinrichtung der Schnittstellenvorrichtung gemessen bzw. bestimmt werden. Die Anzeigeeinheit könnte in Form eines LCD-Monitors ausgebildet sein, welche in einer Fahrzeugkabine des Fahrzeugs angeordnet sein könnte.

Zur Übertragung der von der Messeinrichtung gemessenen bzw. detektierten elektrischen Zustandsgrößen, welche üblicherweise in Form von elektrischen Signalen in analoger oder digitaler Form repräsentiert werden, und/oder zur Übertragung von Steuer- bzw. Regelbefehlen an die Stelleinrichtung könnte zweckmäßigerweise eine Datenschnittstelle vorgesehen sei. Vorzugsweise handelt es sich bei der Datenschnittstelle um eine standardisierte Datenschnittstelle, beispielsweise um einen CAN-Bus.

Zur Realisierung eines möglichst effizienten Energiemanagements der von der (den) Energiequelle(n) des Fahrzeugs zur Verfügung gestellten elektrischen Energie und/oder zur Steuerung des Verbrauchs elektrischer Energie der elektrischen Verbraucher des Fahrzeugs und des Arbeitsgeräts könnte eine Steuereinrichtung vorgesehen sein, mit welcher die elektrische Energieversorgung der elektrischen Energiequellen und/oder der wesentlichen elektrischen Verbraucher steuerbar bzw. regelbar ist. Vorzugsweise sind der Steuereinrichtung die von der Messeinrichtung ermittelten elektrischen Zustandsgrößen zuleitbar. Die Steuereinrichtung könnte die Stelleinrichtung zum Verändern mindestens einer elektrischen Zustandsgröße der zwischen dem Fahrzeug und dem Arbeitsgerät übertragenen elektrischen Energie ansteuern.

Bezüglich eines Fahrzeugs bzw. eines Arbeitsgeräts wird die eingangs genannte Aufgabe durch die Merkmale der Patentansprüche 29 bzw. 30 gelöst. Hiernach ist ein erfindungsgemäßes Fahrzeug, insbesondere ein landwirtschaftliches oder industrielles Nutzfahrzeug, gekennzeichnet durch eine Schnittstellenvorrichtung nach einem der Patentansprüche 1 bis 30. Ein erfindungsgemäßes Arbeitsgerät, welches an ein Fahrzeug ankoppelbar ist, ist gekennzeichnet durch eine Schnittstellenvorrichtung nach einem der Patentansprüche 1 bis 30. Letztendlich weist das erfindungsgemäße Fahrzeug bzw. das erfindungsgemäße Arbeitsgerät Komponenten der Schnittstellenvorrichtung gemäß den Patentansprüchen 1 bis 30 auf, so dass zur Vermeidung von Wiederholungen auf den vorangegangenen Teil der Beschreibung verwiesen werden darf.

Es gibt nun verschiedene Möglichkeiten, die Lehre der vorliegenden Erfindung in vorteilhafter Weise auszugestalten und weiterzubilden. Dazu ist einerseits auf die dem Patentanspruch 1 nachgeordneten Patentansprüchen und andererseits auf die nachfolgende Erläuterung eines bevorzugten Ausführungsbeispiels der Erfindung anhand der Zeichnung zu verweisen. In Verbindung mit der Erläuterung des bevorzugten Ausführungsbeispiels der Erfindung anhand der Zeichnung werden auch im Allgemeinen bevorzugte Ausgestaltungen und Weiterbildungen der Lehre erläutert. In der Zeichnung zeigen jeweils in einer schematischen Darstellung
- Fig. 1: eine aus dem Stand der Technik bekannte Schnittstellenvorrichtung,
- Fig. 2: ein erstes Ausführungsbeispiel einer erfindungsgemäßen Schnittstellenvorrichtung und
- Fig. 3: ein weiteres Ausführungsbeispiel einer erfindungsgemäßen Schnittstellenvorrichtung.

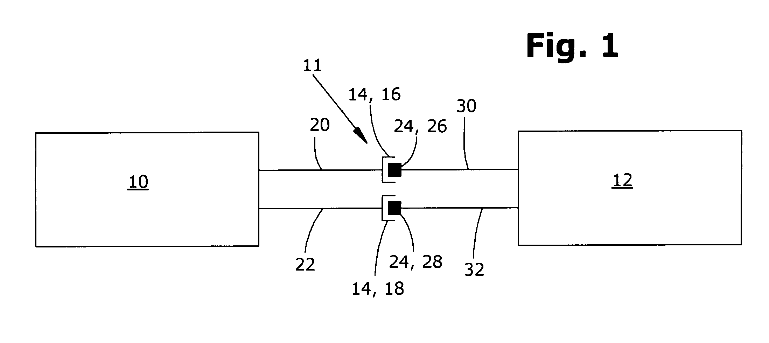

Figur 1 zeigt eine elektrische Energiequelle 10 eines in Figur 1 nicht gezeigten Fahrzeugs. Bei der elektrischen Energiequelle 10 handelt es sich um einen elektrischen Generator. Weiterhin zeigt Figur 1 einen elektrischen Verbraucher 12, welcher einem in Figur 1 nicht gezeigten Arbeitsgerät zugeordnet ist. Bei dem elektrischen Verbraucher 12 handelt es sich um einen Elektromotor, der eine - nicht gezeigte - Welle des Arbeitsgeräts mechanisch antreibt. Die Schnittstellenvorrichtung 11 aus Figur 1 umfasst eine Fahrzeugschnittstelle 14, welche zwei Steckdosen 16, 18 aufweist. Die Steckdosen 16, 18 sind jeweils mit den Leitungen 20, 22 mit der elektrischen Energiequelle 10 verbunden. Die Arbeitsgeräteschnittstelle 24 umfasst zwei Stecker 26, 28, welche jeweils über die Leitungen 30, 32 mit dem elektrischen Verbraucher 12 verbunden sind.

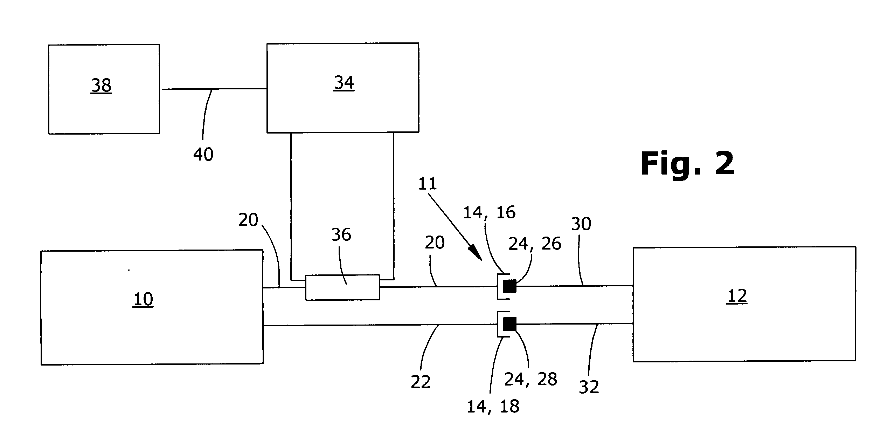

Gleichen oder ähnlichen Baugruppen bzw. Komponenten in den Figuren sind dieselben Bezugszeichen zugeordnet. Figur 2 zeigt demnach ebenfalls eine in Form eines elektrischen Generators ausgebildete elektrische Energiequelle 10 sowie einen in Form eines Elektromotors ausgebildeten elektrischen Verbraucher 12. Auch hier ist eine Fahrzeugschnittstelle 14 mit zwei Steckdosen 16, 18 vorgesehen. Die Steckdosen 16, 18 sind über die Leitungen 20, 22 mit der elektrischen Energiequelle 10 unmittelbar verbunden. Eine mittelbare Leitungsverbindung zwischen der elektrischen Energiequelle 10 und der Fahrzeugschnittstelle 14 wäre ebenfalls denkbar. Die erfindungsgemäße Schnittstellenvorrichtung 11 aus Figur 2 umfasst eine Messeinrichtung 34, mit welcher eine elektrische Zustandsgröße der zwischen dem Fahrzeug und dem Arbeitsgerät übertragenen elektrischen Energie quantifizierbar ist, nämlich im Konkreten einen Spannungsabfall. Der Messeinrichtung 34 ist ein Messwiderstand 36 zugeordnet, welcher in der Nähe der Fahrzeugschnittstelle 14 in der Leitung 20 vorgesehen ist. Mit der Messeinrichtung 34 kann der Spannungsabfall an dem Messwiderstand 36 bestimmt werden. Die Messeinrichtung 34 erzeugt aufgrund des gemessenen Spannungsabfalls ein elektrisches Signal, welches von dem Spannungsabfall abhängt, und übermittelt dieses einer Steuereinrichtung 38. Mit der lediglich schematisch dargestellten Steuereinrichtung 38 ist das Energiemanagement des Fahrzeugs steuer- bzw. regelbar. Die Steuereinrichtung 38 ist über eine in Form eines CAN-Bus ausgestaltete Datenschnittstelle 40 mit der Messeinrichtung 34 verbunden. An der Datenschnittstelle 40 sind weitere Einheiten angeschlossen, welche jedoch in der Figur 2 nicht gezeigt sind. Hierzu zählt insbesondere die Steuereinheit eines Verbrennungsmotors des Fahrzeugs sowie eine in dem Fahrzeug vorgesehene Leistungselektronik.

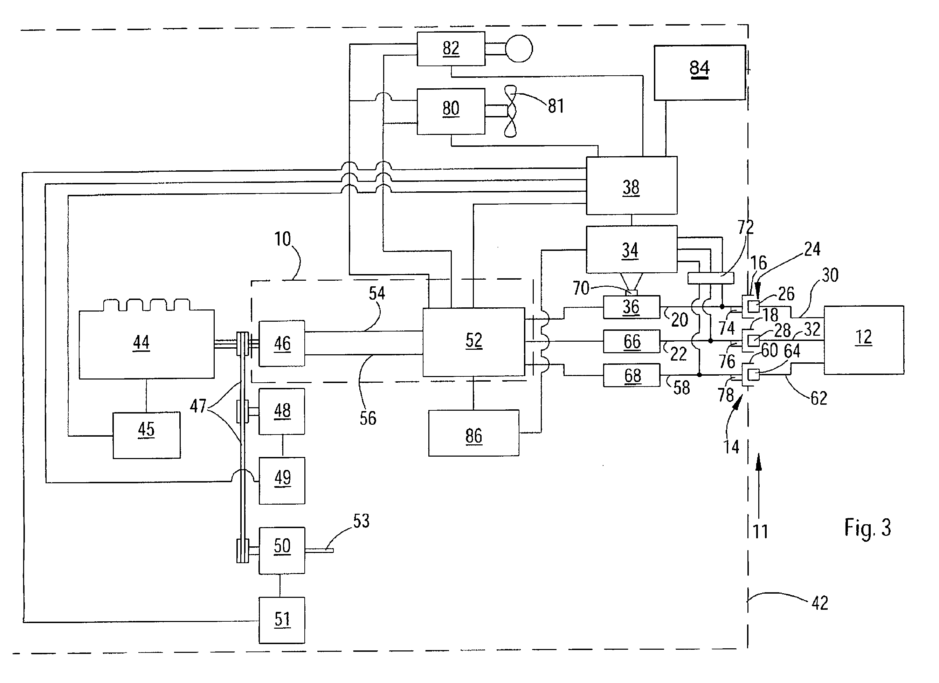

Figur 3 zeigt in einer schematischen Darstellung ein weiteres Ausführungsbeispiel der vorliegenden Erfindung. Hierbei sind die Komponenten, die dem Fahrzeug zugeordnet sind, in dem gestrichelt eingezeichnet Rechteck 42 gezeigt, wobei im Folgenden mit dem Bezugszeichen 42 der Einfachheit halber das Fahrzeug bezeichnet wird. Das Fahrzeug 42 umfasst einen Verbrennungsmotor 44, mit welchem der elektrische Generator 46 sowie das Getriebe 48 für den Fahrantrieb des Fahrzeugs 42 und ein Zapfwellengetriebe 50 mechanisch antreibbar ist. Bei dem Fahrzeug 42 handelt es sich um einen Traktor, welcher eine dem Zapfwellengetriebe 50 nachgeordnete Zapfwelle 53 aufweist, mit welcher ein rein mechanisch angetriebenes und an den Traktor adaptierbares Arbeitsgerät antreibbar ist. Der mechanische Antrieb des elektrischen Generators 46, des Getriebes 48 und des Zapfwellengetriebes 50 ist schematisch mit dem mechanischen Übertragungsmittel 47 gekennzeichnet, wobei es sich bei dem mechanischen Übertragungsmittel 47 um eine Wellen- oder Zahnradstufenanordnung handeln könnte, mit welcher der elektrische Generator 46, das Getriebe 48 und das Zapfwellengetriebe 50 mechanisch in Reihe und/oder parallel zueinander angeordnet sein könnten. Das Arbeitsgerät könnte allerdings auch sowohl mechanisch antreibbar als auch mit einem elektrischen Verbraucher bestückt ausgestattet sein. Der Verbrennungsmotor 44 wird von der Verbrennungsmotoransteuerung 45 angesteuert. Das Getriebe 48 wird von der Getriebeansteuerung 49 angesteuert. Das Zapfwellengetriebe 50 wird von der Zapfwellengetriebeansteuerung 51 angesteuert. Die Verbrennungsmotoransteuerung 45, die Getriebeansteuerung 49 und die Zapfwellengetriebeansteuerung 51 sind über entsprechende Verbindungsleitungen mit der Steuereinrichtung 38 verbunden.

Der Generator 46 ist mit der Leistungselektronikeinrichtung 52 elektrisch gekoppelt. Die Leistungselektronikeinrichtung 52 umfasst Bauteile, mit welchen die elektrische Leistung steuerbar ist, welche über die Fahrzeugschnittstelle 14 dem elektrischen Verbraucher 12 des Arbeitsgeräts steuerbar ist. Dementsprechend umfasst die elektrische Energiequelle 10 des Fahrzeugs 42 aus Figur 3 zumindest den elektrischen Generator 46 und die Leistungselektronikeinrichtung 52, welche über Leitungen 54, 56 miteinander gekoppelt sind.

Die Leistungselektronikeinheit 52 umfasst einen Umrichter (nicht gezeigt), welcher den von dem Generator 46 erzeugten Wechselstrom in Gleichstrom umwandelt. Die Leistungselektronikeinheit 52 umfasst einen weiteren Umrichter (nicht gezeigt), mit welchem der Gleichstrom in Drehstrom vorgebbarer Frequenz, Phase, Spannung und Stromstärke umgewandelt werden kann. Dieser Drehstrom kann dann über die Leitungen 20, 22, 58 dem elektrischen Verbraucher 12 Arbeitsgeräts zur Verfügung gestellt werden. Insoweit weist die Leistungselektronikeinheit 52 die Funktion einer Stelleinrichtung auf und wird der Einfachheit halber ebenfalls mit dem Bezugszeichen 52 bezeichnet. Die Stelleinrichtung 52 ist über die Steuereinrichtung 38 derart ansteuerbar, dass die Fahrzeugschnittstelle 14 spannungsfrei schaltbar ist. Alternativ oder zusätzlich sind mit der Stelleinrichtung 52 in Verbindung mit der Steuereinrichtung 38 elektrische Zustandsgrößen an der Fahrzeugschnittstelle 14 veränderbar.

Zwischen der Leistungselektronikeinheit 52 und dem Arbeitsgerät 12 sind drei Leitungen vorgesehen, nämlich einerseits die Leitungen 20, 22 und 58, welche zwischen der elektrischen Energiequelle 10 und den drei Steckdosen 16, 18, 60 der Fahrzeugschnittstelle 14 und andererseits die Leitungen 30, 32 und 62 vorgesehen, welche zwischen dem elektrischen Verbraucher 12 und den Stecker 26, 28 und 64 der Arbeitsgerätschnittstelle 24 verlaufen. Dementsprechend handelt es sich bei der in Figur 3 gezeigte Schnittstellenvorrichtung 11 um einen elektrische Schnittstelle zu Übertragen von Drehstrom zwischen der elektrischen Energiequelle 10 des Fahrzeugs 42 und dem elektrischen Verbraucher 12 des Arbeitsgeräts.

An jeder Leitung 20, 22 und 58 ist ein Messwiderstand 36, 66 und 68 vorgesehen, an welchem jeweils eine Strommessung erfolgen kann.

Lediglich schematisch ist angedeutet, wie an dem Messwiderstand 36 ein Temperatursensor 70 angeordnet ist, mit welchem die Temperatur des Messwiderstands 36 detektierbar ist. In gleicher Weise können an Messwiderständen 66 und 68 ebenfalls Temperatursensoren (nicht gezeigt) angeordnet sein. Ebenfalls lediglich schematisch angedeutet ist eine Spannungsmesseinrichtung 72 gezeigt, mit welcher die momentan anliegende Spannung jeweils zwischen den Leitungen 20, 22, 58 detektierbar ist. Unmittelbar in räumlicher Nähe der Steckdose 16, 18 und 60 ist jeweils ein in Form eines Hall-Sensors ausgebildeter Magnetfeldsensor 74, 76 und 78 angeordnet, mit welchem das jeweils aktuell vorliegende Magnetfeld detektierbar ist. Mit einem Magnetfeldsensor 74, 76 und 78 ist das Magnetfeld detektierbar bzw. quantifizierbar, welches durch den elektrischen Stromfluss durch die jeweilige Leitung 20, 22, 58 zwischen dem Fahrzeug 42 und dem Arbeitsgerät verursacht wird. Als jeweils eine bauliche Einheit ist ein Hall-Sensor 74, 76 und 78 mit jeweils einer Sicherung (nicht extra gezeigt) vorgesehen, wobei mit der elektrischen Sicherung der über die jeweilige Leitung 20, 22, 58 fließende Strom begrenzbar ist.

Ebenfalls mit elektrischem Strom (in diesem Fall mit Wechselstrom) werden die weiteren elektrischen Verbraucher 80, 82 von der Leistungselektronikeinrichtung beziehungsweise Stelleinrichtung 52 versorgt. Einerseits handelt es sich bei dem elektrischen Verbraucher 80 um den Elektromotor eines Lüfters 81 für einen in Figur 3 nicht gezeigten Kühler des Fahrzeugs 42. Andererseits handelt es sich bei dem elektrischen Verbraucher 82 um den Elektromotor, mit welchem der Kompressor der in Figur 3 nicht weiter gezeigten Klimaanlage des Fahrzeugs 42 angetrieben wird.

Es ist eine Anzeigeeinheit 84 vorgesehen, mit welcher mindestens eine der im Folgenden aufgezählten, an der Schnittstellenvorrichtung 11 vorherrschenden Zustandsgrößen anzeigbar ist: der elektrische Strom, die elektrische Spannung, die elektrische Leistung, die Belastungskennzahl, der Verbraucherwiderstand und/oder die elektrische Energie. Die Anzeigeeinheit 84 weist weiterhin die Funktionalität einer Warneinrichtung auf, mit welcher ein Fahrzeugbediener beim Überschreiten eines vorgebbaren Grenzwerts einer elektrischen Zustandsgröße gewarnt wird. Dies könnte durch ein akustisches und/oder optisches Signal erfolgen.

Obwohl dies in den Figuren 1 bis 3 auf Grund einer deutlichen Darstellung der in diesem Ausführungsbeispiel vorgesehenen Komponenten nicht explizit gezeigt ist, ist sowohl die Messeinrichtung 34 als auch die Stelleinrichtung 52 jeweils der Fahrzeugschnittstelle 14 zugeordnet. Mit der in Figur 3 gezeigten Stelleinrichtung 52 werden weitere elektronische Verbraucher 80, 82 mit elektrischer Leistung versorgt. Hierzu könnte jedoch auch eine separate, von der Fahrzeugschnittstelle 14 räumlich getrennt angeordnete weitere Stelleinrichtung vorgesehen sein.

Mit dem in Figur 3 gezeigten Fahrzeug 42 können in ganz besonders vorteilhafter Weise mehrere Regelstrategien zum Betreiben des Fahrzeugs 42 realisiert werden, und zwar in Abhängigkeit, wie die Steuereinrichtung 38 ausgebildet bzw. programmiert ist. Die Steuereinrichtung 38 kennt nämlich die von der Messeinrichtung 34 übermittelten elektrischen Zustandsgrößen der über die Schnittstellenvorrichtung 11 übertragenen elektrischen Leistung. Weiterhin ist die Stelleinrichtung 52 mit der Verbrennungsmotoransteuerung 45, der Getriebeansteuerung 49, der Zapfwellengetriebeansteuerung 51 sowie den weiteren elektronischen Verbrauchern 80, 82 wirkverbunden. Somit kann in Abhängigkeit des aktuell vorliegenden Betriebszustands des Fahrzeugs 42 mit der Steuereinrichtung 38 die Drehzahl des Verbrennungsmotors 44 und/oder die Drehzahl der Zapfwelle 53 (durch eine entsprechende Ansteuerung des Zapfwellengetriebes 50) und/oder durch entsprechende Ansteuerung des Getriebes 48 die Drehzahl des in Figur 3 nicht gezeigten, vom Getriebe 48 angetriebenen Fahrantriebs angesteuert und/oder geregelt werden. Hierdurch kann beispielsweise die Gesamtleistung des Fahrzeugs optimiert werden. Es ist auch denkbar, dass der Kraftstoffverbrauch des Fahrzeugs durch eine entsprechende Ansteuerung minimierbar ist. Eine hierzu erforderliche Fahrzeugsteuereinrichtung stellt die in Figur 3 gezeigte Steuereinrichtung 38 dar, welche gleichzeitig die Funktion einer Regeleinrichtung aufweist.

Die Steuereinrichtung 38 weist weiterhin die Funktionalität eines Priorisierungsmittels auf. Mit ihm kann eine Priorisierung der elektrischen Energieversorgung der am Fahrzeug 42 vorgesehenen elektrischen Verbraucher 80, 82 und des elektrischen Verbrauchers 12 des Arbeitsgeräts priorisiert werden. Auch dies kann Gegenstand einer Ansteuer- bzw. Regelstrategie für das Fahrzeug 42 sein.

Es ist ein elektrischer Speicher 86 vorgesehen, welcher in Form eines Kondensators ausreichender Kapazität (für kurzzeitige Zwischenspeicherung elektrische Energie) oder welcher in Form eines Akkumulators ausgebildet sein kann. Die aktuell vorliegende elektrische Zustandsgröße des elektrischen Speichers 86 ist ebenfalls detektierbar, was schematisch mit einer Verbindungsleitung zwischen dem elektrischen Speicher 86 und der Messeinrichtung 34 angedeutet ist.

Abschließend sei ganz besonders darauf hingewiesen, dass das voranstehend erörterte Ausführungsbeispiel lediglich zur Beschreibung der beanspruchten Lehre dienen, diese jedoch nicht auf das Ausführungsbeispiel einschränken.

## Patentansprüche

1. Elektrische Schnittstellenvorrichtung zum Übertragen elektrischer Energie zwischen einem Fahrzeug und einem an dem Fahrzeug ankoppelbaren Arbeitsgerät, mit einer Fahrzeugschnittstelle (14) und einer Arbeitsgeräteschnittstelle (24), wobei die Fahrzeugschnittstelle (14) komplementär zur Arbeitsgeräteschnittstelle (24) ausgebildet und mit dieser reversibel verbindbar ist; mit elektrischen Leitungen (20, 22, 30, 32), mittels welchen einerseits die Fahrzeugschnittstelle (14) mit einer elektrischen Energiequelle (10) des Fahrzeugs und andererseits die Arbeitsgeräteschnittstelle (24) mit einem elektrischen Verbraucher (12) verbunden ist; mit einer der Fahrzeugschnittstelle (14) zugeordneten Messeinrichtung (34), mittels welcher ein Istwert einer elektrischen Zustandsgröße der zwischen dem Fahrzeug und dem Arbeitsgerät übertragenen elektrischen Energie ermittelt wird; mit einer der Fahrzeugschnittstelle (14) zugeordneten Stelleinrichtung, mittels welcher der Istwert der elektrischen Zustandsgröße verändert wird; und mit einer Regeleinrichtung zur Regelung der elektrischen Zustandsgröße, wobei mittels der Regeleinrichtung der von der Messeinrichtung (34) ermittelte Istwert der elektrischen Zustandsgröße mit einem vorgegebenen Sollwert der elektrischen Zustandsgröße verglichen wird, **dadurch gekennzeichnet, dass** bei einer Abweichung des Istwerts der elektrischen Zustandsgröße vom Sollwert der elektrischen Zustandsgröße mittels der Stelleinrichtung die Drehzahl eines Verbrennungsmotors und/oder die Fahrgeschwindigkeit des Fahrzeugs derart verändert wird, dass die Abweichung minimiert wird.

2. Schnittstellenvorrichtung nach Anspruch 1, **dadurch gekennzeichnet, dass** mittels der Messeinrichtung (34) ein zwischen dem Fahrzeug und dem Arbeitsgerät fließender elektrischer Strom ermittelt wird.

3. Schnittstellenvorrichtung nach Anspruch 1 oder 2, **dadurch gekennzeichnet, dass** in einer der Leitungen (20) ein Messwiderstand (36) vorgesehen ist, an welchem zur Ermittlung des elektrischen Stroms mittels einer Spannungsmesseinheit (34) ein Spannungsabfall erfassbar ist.

4. Schnittstellenvorrichtung nach einem der Ansprüche 1 bis 3, **dadurch gekennzeichnet, dass** in einer der Leitungen ein Messwiderstand vorgesehen ist, an welchem mittels eines Temperatursensors ein Temperaturverlauf oder eine Erwärmung erfassbar ist.

5. Schnittstellenvorrichtung nach einem der Ansprüche 1 bis 4, **dadurch gekennzeichnet, dass** in einer der Leitungen eine elektrische Sicherung vorgesehen ist, an welcher zur Ermittlung des elektrischen Stroms mittels einer Spannungsmesseinheit ein Spannungsabfall erfassbar ist.

6. Schnittstellenvorrichtung nach einem der Ansprüche 1 bis 5, **dadurch gekennzeichnet, dass** zur Ermittlung des elektrischen Stroms mittels einer Spannungsmesseinheit der Spannungsabfall an einem dafür vorgesehenen Leitungsabschnitt erfassbar ist.

7. Schnittstellenvorrichtung nach einem der Ansprüche 1 bis 6, **dadurch gekennzeichnet, dass** zur Ermittlung des elektrischen Stroms mittels einer Spannungsmesseinheit der Spannungsabfall an einem Schaltelement erfassbar ist.

8. Schnittstellenvorrichtung nach einem der Ansprüche 1 bis 7, **dadurch gekennzeichnet, dass** in unmittelbarer Nähe einer der Leitungen ein Magnetfeldsensor vorgesehen ist, mittels welchem ein durch den elektrischen Strom verursachtes Magnetfeld erfassbar ist.

9. Schnittstellenvorrichtung nach Anspruch 8, **dadurch gekennzeichnet, dass** der Magnetfeldsensor einen Hallsensor aufweist.

10. Schnittstellenvorrichtung nach einem der Ansprüche 1 bis 9, **dadurch gekennzeichnet, dass** die Stelleinrichtung derart ausgebildet ist, dass die Fahrzeugschnittstelle (14) spannungsfrei schaltbar ist.

11. Schnittstellenvorrichtung nach einem der Ansprüche 1 bis 10, **dadurch gekennzeichnet, dass** im Falle einer Abweichung des Istwerts der elektrischen Zustandsgröße vom Sollwert der elektrischen Zustandsgröße mittels der Stelleinrichtung die Drehzahl des Verbrennungsmotors des Fahrzeugs derart verändert wird, dass der Kraftstoffverbrauch minimiert wird.

12. Schnittstellenvorrichtung nach einem der Ansprüche 1 bis 11, **dadurch gekennzeichnet, dass** ein Priorisierungsmittel vorgesehen ist, mittels welchem die elektrische Energieversorgung von am Fahrzeug und am Arbeitsgerät vorgesehenen elektrischen Verbrauchern (12) priorisierbar ist.

13. Schnittstellenvorrichtung nach einem der Ansprüche 1 bis 12, **dadurch gekennzeichnet, dass** bei Überschreiten eines für die elektrische Zustandsgröße vorgebbaren Grenzwerts die Leistung des Verbrennungsmotors des Fahrzeugs verändert wird und/oder selbsttätige Sicherungsmaßnahmen erfolgen.

14. Schnittstellenvorrichtung nach einem der Ansprüche 1 bis 13, **dadurch gekennzeichnet, dass** die reversible Verbindung zwischen der Fahrzeugschnittstelle (14) und der Arbeitsgeräteschnittstelle (24) mittels einer Klemmverbindung oder einer Schraubverbindung herstellbar ist.

15. Schnittstellenvorrichtung nach einem der Ansprüche 1 bis 14, **dadurch gekennzeichnet, dass** eine Warneinrichtung vorgesehen ist, mittels welcher ein Fahrzeugbediener beim Überschreiten eines für die elektrische Zustandsgröße vorgebbaren Grenzwerts gewarnt wird.

16. Schnittstellenvorrichtung nach einem der Ansprüche 1 bis 15, **dadurch gekennzeichnet, dass** eine Datenschnittstelle (40) vorgesehen ist, mittels welcher oder elektrischen Zustandsgröße von der Messeinrichtung (34) an die Stelleinrichtung übermittelt wird, wobei die Datenschnittstelle (40) vorzugsweise einen CAN-Bus aufweist.

17. Fahrzeug, bestehend aus einem Fahrzeug und einem daran angekoppelten Arbeitsgerät, **gekennzeichnet durch** eine Schnittstellenvorrichtung (11) nach einem der Ansprüche 1 bis 16.

## Claims

1. Electrical interface apparatus for transmitting electrical energy between a vehicle and an implement which can be coupled to the vehicle, having a vehicle interface (14) and an implement interface (24), with the vehicle interface (14) being formed so as to complement the implement interface (24) and it being possible for the said vehicle interface to be connected to the said implement interface in a reversible manner; having electrical lines (20, 22, 30, 32) by means of which firstly the vehicle interface (14) is connected to an electrical energy source (10) of the vehicle and secondly the implement interface (24) is connected to an electrical load (12); having a measuring device (34) which is associated with the vehicle interface (14) and by means of which an actual value of an electrical state variable of the electrical energy which is transmitted between the vehicle and the implement is determined; having an actuating device which is associated with the vehicle interface (14) and by means of which the actual value of the electrical state variable is changed; and having a regulating device for regulating the electrical state variable, with the actual value of the electrical state variable, which actual value is determined by the measuring device (34), being compared with a predefined setpoint value of the electrical state variable by means of the regulating device, **characterized in that**, when the actual value of the electrical state variable deviates from the setpoint value of the electrical state variable, the rotation speed of an internal combustion engine and/or the travelling speed of the vehicle is changed by means of the actuating device in such a way that the deviation is minimized.

2. Interface apparatus according to Claim 1, **characterized in that** an electric current flowing between the vehicle and the implement is determined by means of the measuring device (34).

3. Interface apparatus according to Claim 1 or 2, **characterized in that** a measuring resistor (36) is provided in one of the lines (20), it being possible to detect a voltage drop across the said measuring resistor by means of a voltage measuring unit (34) in order to determine the electric current.

4. Interface apparatus according to one of Claims 1 to 3, **characterized in that** a measuring resistor is provided in one of the lines, it being possible to detect a temperature profile or heating across the said measuring resistor by means of a temperature sensor.

5. Interface apparatus according to one of Claims 1 to 4, **characterized in that** an electrical fuse is provided in one of the lines, it being possible to detect a voltage drop across the said electrical fuse by means of a voltage measuring unit in order to determine the electric current.

6. Interface apparatus according to one of Claims 1 to 5, **characterized in that** the voltage drop across a line section, which is provided for the stated purpose, can be detected by means of a voltage measuring unit in order to determine the electric current.

7. Interface apparatus according to one of Claims 1 to 6, **characterized in that** the voltage drop across a switching element can be detected by means of a voltage measuring unit in order to determine the electric current.

8. Interface apparatus according to one of Claims 1 to 7, **characterized in that** a magnetic field sensor is provided in the immediate vicinity of one of the lines, it being possible for a magnetic field which is produced by the electric current to be detected by means of the said magnetic field sensor.

9. Interface apparatus according to Claim 8, **characterized in that** the magnetic field sensor has a Hall sensor.

10. Interface apparatus according to one of Claims 1 to 9, **characterized in that** the actuating device is formed in such a way that the vehicle interface (14) can be switched so that no voltage is applied.

11. Interface apparatus according to one of Claims 1 to 10, **characterized in that**, when the actual value of the electrical state variable deviates from the setpoint value of the electrical state variable, the rotation speed of the internal combustion engine of the vehicle is changed by means of the actuating device in such a way that the fuel consumption is minimized.

12. Interface apparatus according to one of Claims 1 to 11, **characterized in that** a prioritization means is provided, it being possible to prioritize the supply of electrical energy to electrical loads (12) which are provided on the vehicle and on the implement by means of the said prioritization means.

13. Interface apparatus according to one of Claims 1 to 12, **characterized in that** the power of the internal combustion engine of the vehicle is changed and/or automatic safety measures take place when a limit value which can be predefined for the electrical state variable is exceeded.

14. Interface apparatus according to one of Claims 1 to 13, **characterized in that** the reversible connection between the vehicle interface (14) and the implement interface (24) can be established by means of a clamping connection or a screw connection.

15. Interface apparatus according to one of Claims 1 to 14, **characterized in that** a warning device is provided, the said warning device warning a vehicle operator when a limit value which can be predefined for the electrical state variable is exceeded.

16. Interface apparatus according to one of Claims 1 to 15, **characterized in that** a data interface (40) is provided, the said data interface transmitting the electrical state variable from the measuring device (34) to the actuating device, with the data interface (40) preferably having a CAN bus.

17. Vehicle comprising a vehicle and an implement which is coupled to the said vehicle, **characterized by** an interface apparatus (11) according to one of Claims 1 to 16.

## Revendications

1. Ensemble interfaces électriques pour la transmission d'énergie électrique entre un véhicule et une machine de travail pouvant être couplée au véhicule, avec une interface de véhicule (14) et une interface de machine de travail (24), l'interface de véhicule (14) étant complémentaire de l'interface de machine de travail (24) et pouvant être reliée à elle de façon réversible ; avec des conduites électriques (20, 22, 30, 32) à l'aide desquelles d'une part l'interface de véhicule (14) est reliée à une source d'énergie électrique (10) du véhicule et d'autre part l'interface de machine de travail (24) est reliée à un dissipateur électrique (12) ; avec un dispositif de mesure (34) associé à l'interface de véhicule (14) à l'aide duquel une valeur réelle d'une grandeur d'état électrique de l'énergie électrique transmise entre le véhicule et la machine de travail est calculée ; avec un dispositif de positionnement associé à l'interface de véhicule (14) utilisé pour faire varier la valeur réelle de la grandeur d'état électrique ; et avec un dispositif de réglage pour régler la grandeur d'état électrique, la valeur réelle de la grandeur d'état électrique calculée par le dispositif de mesure (34) étant comparée à une valeur théorique prédéfinie de la grandeur d'état électrique à l'aide du dispositif de réglage, **caractérisé en ce qu'**en cas d'écart de la valeur réelle de la grandeur d'état électrique, le nombre de tours d'un moteur à combustion et/ou la vitesse de conduite du véhicule sont modifiés par rapport à la valeur théorique de la grandeur d'état électrique à l'aide du dispositif de positionnement de façon à minimiser cet écart.

2. Ensemble interfaces selon la revendication 1, **caractérisé en ce qu'**un courant électrique circulant entre le véhicule et la machine de travail est calculé à l'aide du dispositif de mesure (34).

3. Ensemble interfaces selon la revendication 1 ou 2, **caractérisé en ce qu'**une résistance de mesure (36) est prévue dans une des conduites (20) au niveau de laquelle une chute de tension peut être détectée pour déterminer le courant électrique à l'aide d'une unité de mesure de tension (34).

4. Ensemble interfaces selon l'une quelconque des revendications 1 à 3, **caractérisé en ce qu'**une résistance de mesure est prévue dans une des conduites au niveau de laquelle une circulation de température ou un échauffement peuvent être détectés à l'aide d'un capteur de température.

5. Ensemble interfaces selon l'une quelconque des revendications 1 à 4, **caractérisé en ce qu'**un fusible électrique est prévu dans une des conduites au niveau duquel une chute de tension peut être détectée à l'aide d'une unité de mesure de tension pour déterminer le courant électrique.

6. Ensemble interfaces selon l'une quelconque des revendications 1 à 5, **caractérisé en ce que** la chute de tension peut être détectée au niveau d'un segment de conduite prévu à cette fin pour déterminer le courant électrique à l'aide d'une unité de mesure de tension.

7. Ensemble interfaces selon l'une quelconque des revendications 1 à 6, **caractérisé en ce que** la chute de tension peut être détectée au niveau d'un élément de commutation pour déterminer le courant électrique à l'aide d'une unité de mesure de tension.

8. Ensemble interfaces selon l'une quelconque des revendications 1 à 7, **caractérisé en ce qu'**un capteur de champ magnétique est prévu à proximité immédiate d'une des conduites à l'aide duquel un champ magnétique engendré par le courant électrique peut être détecté.

9. Ensemble interfaces selon la revendication 8, **caractérisé en ce que** le capteur de champ magnétique comporte un capteur de Hall.

10. Ensemble interfaces selon l'une quelconque des revendications 1 à 9, **caractérisé en ce que** le dispositif de positionnement est réalisé de telle sorte que l'interface de véhicule (14) peut être commutée hors tension.

11. Ensemble interfaces selon l'une quelconque des revendications 1 à 10, **caractérisé en ce qu'**en cas d'écart entre la valeur réelle de la grandeur d'état électrique et la valeur théorique de la grandeur d'état électrique, le nombre de tours du moteur à combustion du véhicule peut être modifié à l'aide du dispositif de positionnement de façon à réduire la consommation de carburant.

12. Ensemble interfaces selon l'une quelconque des revendications 1 à 11, **caractérisé en ce qu'**un moyen d'établissement des priorités est prévu à l'aide duquel l'alimentation en énergie électrique peut être prioritisée au niveau des dissipateurs électriques (12) prévus au niveau du véhicule et au niveau de la machine de travail.

13. Ensemble interfaces selon l'une quelconque des revendications 1 à 12, **caractérisé en ce que** la puissance du moteur à combustion du véhicule est modifiée en cas de dépassement d'une valeur limite prédéfinie pour la grandeur d'état électrique et/ou que des mesures de sécurité indépendantes sont prises.

14. Ensemble interfaces selon l'une quelconque des revendications 1 à 13, **caractérisé en ce que** la liaison réversible entre l'interface de véhicule (14) et l'interface de machine de travail (24) peut être établie à l'aide d'une jonction par serrage ou d'une jonction par vissage.

15. Ensemble interfaces selon l'une quelconque des revendications 1 à 14, **caractérisé en ce qu'**un dispositif d'avertissement est prévu à l'aide duquel un utilisateur du véhicule est averti en cas de dépassement d'une valeur limite prédéfinie de la grandeur d'état électrique.

16. Ensemble interfaces selon l'une quelconque des revendications 1 à 15, **caractérisé en ce qu'**une interface de données (40) est prévue à l'aide de laquelle la grandeur d'état électrique du dispositif de mesure (34) est déterminée au niveau du dispositif de positionnement, l'interface de données (40) comportant de préférence un bus CAN.

17. Véhicule, composé d'un véhicule et d'une machine de travail raccordée à lui, **caractérisé** pasr un ensemble interfaces (11) selon l'une quelconque des revendications 1 à 16.
